# FASCICULE DE BREVET EUROPEEN

(11) **EP 4 564 664 B1**
(45) Date de publication et mention de la délivrance du brevet: **22.07.2026**
(21) Numéro de dépôt: 24216145.3
(22) Date de dépôt: 28.11.2024
(51) Int. Cl.: H02S 30/10, H10F 19/80, H10F 71/00

(54) **DISPOSITIF PHOTOVOLTAÏQUE**
PHOTOVOLTAIKVORRICHTUNG
PHOTOVOLTAIC DEVICE

(30) Priorité: 01.12.2023 FR 2313448
(43) Date de publication de la demande: 04.06.2025
(73) Titulaire: Commissariat à l'Energie Atomique et aux Energies Alternatives, 75015 Paris (FR)
(72) Inventeur: DUFRENE, Gaetan, 38054 GRENOBLE (FR); DE BETTIGNIES, Rémi, 38054 GRENOBLE (FR)
(74) Mandataire: Ipsilon

(56) Documents cités:
- WO-A1-2019/043329
- WO-A1-2019/043331
- WO-A1-2022/065479
- WO-A1-2023/008210
- US-A1- 2022 094 299

## Description

### Domaine technique

La présente invention concerne un dispositif photovoltaïque, un procédé de fabrication d'un tel dispositif, et un procédé de recyclage de celui-ci. Le dispositif photovoltaïque comporte un module photovoltaïque entouré d'un cadre, le module photovoltaïque comportant au moins une cellule photovoltaïque noyée dans un encapsulant comportant un matériau polymère.

### Technique antérieure

Un module photovoltaïque comporte des cellules photovoltaïques destinées à convertir une énergie solaire en énergie électrique. Un tel module photovoltaïque comporte de nombreux matériaux intéressants à récupérer et à valoriser, lorsque le module photovoltaïque est en fin de vie ou défaillant.

En vue de son recyclage, on connait différentes solutions pour séparer les différents matériaux qui le composent, mais qui peuvent être coûteuses en énergie et peu respectueuses de l'environnement.

Dans tous les cas, il est nécessaire de séparer le module photovoltaïque de son cadre pour pouvoir procéder à son recyclage.

Par ailleurs, il peut être utile de séparer le module photovoltaïque de son cadre pour pouvoir réutiliser le module photovoltaïque, le cadre, ou les deux séparément, pour une seconde vie.

On connait par les demandes WO 2019/043329 et WO 2019/043331 des procédés de désassemblage d'un module photovoltaïque. La demande WO 2022/065479 propose un traitement thermique pour le recyclage, et la demande WO 2023/008210 l'utilisation d'un jet d'eau à haute-pression. La demande US2022/094299 concerne le démontage d'un module PV par l'action d'un outil.

Cependant, dans le cas où le dispositif photovoltaïque comporte des éléments électroniques intégrés et des éléments de connexion de ces éléments électroniques intégrés vers l'extérieur du module photovoltaïque, notamment entre le module photovoltaïque et son cadre, il peut être nécessaire de pouvoir séparer le module photovoltaïque de son cadre sans endommager les éléments de connexion, afin de pouvoir réutiliser ceux-ci.

Or les procédés connus peuvent provoquer l'endommagement des éléments de connexion.

Aussi, il existe un besoin pour améliorer encore et faciliter le recyclage d'un dispositif photovoltaïque.

### Résumé de l'invention

La présente invention répond à tout ou partie de ce besoin et a ainsi pour objet un dispositif photovoltaïque, comportant :
- au moins un module photovoltaïque, comportant une face avant et une face arrière entre lesquelles est disposé notamment un encapsulant de cellules photovoltaïques, et
- un cadre entourant le module photovoltaïque, le cadre comportant une gorge pour recevoir un bord du module photovoltaïque,
- un ou plusieurs fils de décadrage disposés dans la gorge, s'étendant au moins en partie longitudinalement au bord du module photovoltaïque.

L'invention permet de faciliter la séparation du cadre et du module photovoltaïque, ce qui facilite le recyclage de celui-ci. L'invention porte sur le dispositif photovoltaïque selon la revendication 1; le procédé de fabrication du dispositif photovoltaïque selon la revendication 9; et le procédé de démontage du dispositif photovoltaïque selon la revendication 14.

### Exposé de l'invention

### Module photovoltaïque

Le module photovoltaïque en tant que tel comporte des cellules photovoltaïques disposées entre une face avant et une face arrière séparée par une tranche du module photovoltaïque, et qui sont reliées électriquement entre elles par des conducteurs de liaison et qui sont immergées entre deux couches avant et arrière de matériau d'encapsulation formant toutes les deux l'encapsulant.

Le module photovoltaïque peut comporter notamment au moins :
- une couche de protection transparente disposée en face avant, par exemple en verre,
- un encapsulant en matériau polymère, par exemple de type élastomère transparent, dans lequel sont encapsulées ou enrobées des cellules photovoltaïques, et
- une couche de protection disposée en face arrière du module photovoltaïque, par exemple en verre également, ou encore par exemple à base de polymères multi-couches définissant une face arrière non transparente, dite *« backsheet ».*

On peut définir des bords du module photovoltaïque, qui définissent son pourtour, étant formés par les bords des face avant et face arrière et de l'encapsulant. On peut définir deux bords opposés, le module photovoltaïque pouvant avoir une forme générale rectangulaire. Les bords peuvent avoir une certaine épaisseur, du fait de la présence des cellules photovoltaïques dans l'encapsulant, de sorte qu'on peut définir des arêtes des bords au niveau des arrêtes supérieure et inférieures, de part et d'autre de la tranche du module photovoltaïque.

### Encapsulant

L'encapsulant peut être formé à partir d'au moins un film avant et un film arrière comportant au moins un matériau d'encapsulation de type polymère choisi parmi : les copolymères d'acides, les ionomères, le poly(éthylène-acétate de vinyle) (EVA), les acétals de vinyle, tels que les polyvinylbutyrals (PVB), les polyuréthanes, les polyéthylènes, tels que les polyéthylènes linéaires basse densité, les polyoléfines élastomères de copolymères, les copolymères d'α-oléfines et des α-, β- esters d'acide carboxylique à éthylénique, tels que les copolymères éthylène-acrylate de méthyle et les copolymères éthylène-acrylate de butyle, les élastomères de silicone et/ou les élastomères à base de polyoléfine thermoplastique réticulée.

Par le terme « encapsulant » ou « encapsulé », il faut comprendre que la pluralité de cellules photovoltaïques est disposée dans un volume, par exemple hermétiquement clos vis-à-vis des liquides et des gaz, au moins en partie formé par au moins deux films de matériau(x) d'encapsulation, réunies entre eux après lamination pour former l'ensemble encapsulant.

En effet, initialement, c'est-à-dire avant toute opération de lamination, l'encapsulant est constitué par au moins deux films de matériau(x) d'encapsulation, entre lesquels la pluralité de cellules photovoltaïques est encapsulée.

Toutefois, pendant l'opération de lamination des films, les films de matériau d'encapsulation fondent pour ne former, après l'opération de lamination, qu'un seul ensemble solidifié dans lequel sont noyées ou enrobées les cellules photovoltaïques.

Un module photovoltaïque peut comporter deux couches de protection, une première couche de protection formant par exemple la face avant et réalisée dans un ou des matériaux transparents choisi dans la liste suivante, qui n'est pas limitative : verre, matériau composite, matière plastique, polymère. Un module photovoltaïque peut comporter une deuxième couche de protection formant la face arrière et réalisée dans un ou des matériaux choisis dans la liste suivante, qui n'est pas limitative : verre, matériau composite, matière plastique, polymère, métaux. Dans le cas où les première et deuxième couches de protection sont réalisées en verre, on parle de module biverre.

### Cadre

Le cadre peut par exemple être en aluminium ou en alliage d'aluminium, comme par exemple un alliage à base d'aluminium de type 6005 ou de type 6063.

Le cadre peut comporter une ou plusieurs parties de cadre, par exemple une, deux, trois ou quatre parties de cadre. Une partie de cadre peut protéger le module photovoltaïque sur un ou plusieurs de ses bords, notamment un seul bord ou deux bords adjacents.

Une partie de cadre peut comporter, lorsqu'observé en section transversale, une gorge recevant un bord du module photovoltaïque. La gorge peut recevoir un produit de scellage, par exemple du silicone, dans lequel est noyé le bord du module photovoltaïque. La gorge peut être remplie de produit de scellage.

Une hauteur de la gorge peut être configurée pour permettre au cadre de recevoir suffisamment de produit de scellage afin d'assurer une bonne étanchéité et le collage du module photovoltaïque dans le cadre. La hauteur de la gorge peut être comprise entre 2 et 6 mm, voire entre 4,8 et 6,0 mm, mieux entre 4,8 et 5,6 mm.

Un espace restant entre les parois de la gorge et les faces du module photovoltaïque peut déterminer le diamètre maximal du fil de décadrage utilisable. Le jeu moyen peut être d'environ 200 µm. Un diamètre maximal du fil de décadrage peut être compris entre 50 et 800 µm, voire entre 100 et 600 µm, mieux entre 150 et 400 µm, encore mieux entre 150 et 250 µm. A titre d'exemple, un fil de nylon de 200 µm de diamètre peut permettre une traction de 4kg. Or la force nécessaire à la découpe du produit de scellage, par exemple du silicone peut être estimée à 1 kgf.

Une partie de cadre peut comporter, lorsqu'observé en section transversale, une cannelure, laquelle peut s'étendre parallèlement à la gorge recevant le bord du module photovoltaïque. La cannelure peut être utilisée pour la fixation du cadre sur un support de cadre par exemple, notamment par boulonnage.

Ainsi, la partie de cadre peut avoir, lorsqu'observé en section transversale, une forme générale de E ou de F, ce qui permet d'améliorer sa rigidité, et donc la rigidité résultante du cadre.

L'une au moins des branches du E, notamment une branche entourant la gorge recevant un bord du module photovoltaïque, peut être chanfreinée. Le chanfrein peut permettre de faciliter l'insertion du produit de scellage dans la gorge et/ou du bord du module photovoltaïque.

Le cadre peut comporter une rainure longitudinale pour recevoir le fil de décadrage, s'étendant notamment parallèlement à la gorge du cadre.

La rainure longitudinale peut être ménagée dans la gorge du cadre. Elle peut permette de bien caler le fil de décadrage et de le maintenir en position.

Dans un mode de réalisation, une partie de cadre peut comporter une rainure longitudinale pour recevoir le fil de décadrage, voire chaque partie de cadre peut comporter une rainure longitudinale pour recevoir le fil de décadrage.

La rainure longitudinale peut être située sur l'une des branches du E, notamment une branche entourant la gorge recevant un bord du module photovoltaïque, en particulier la branche située du côté de la face avant du module photovoltaïque. La rainure longitudinale peut être située sur l'une des branches du E, du côté intérieur de la gorge recevant un bord du module photovoltaïque.

En variante, le cadre peut être dépourvu de rainure longitudinale, notamment dans le cas où la gorge est suffisamment large. Le fil de décadrage peut être placé directement dans la gorge.

### Fil de décadrage

Le dispositif peut comporter un ou plusieurs fils de décadrage, par exemple un, deux, trois ou quatre fils de décadrage. Un fil de décadrage peut être disposé le long d'un ou plusieurs des bords du module photovoltaïque, notamment un seul bord ou deux bords adjacents par fil.

Dans un mode de réalisation, le dispositif comporte un unique fil de décadrage, lequel peut être disposé le long de tous les bords du module photovoltaïque.

Le ou les fils de décadrage sont configurés pour permettre la découpe d'un produit de scellage du module photovoltaïque dans son cadre, et ainsi de séparer le module photovoltaïque de son cadre. Le produit de scellage peut par exemple être du silicone.

Le dispositif photovoltaïque selon l'invention peut être démonté de manière aisée par fragilisation du produit de scellage, notamment d'un produit de scellage silicone, disposé entre le cadre et le module photovoltaïque.

La présence du fil de décadrage permet d'obtenir un décadrage sélectif de tout ou partie du module photovoltaïque de son cadre, sans abimer de possibles éléments de connexion à des éléments électroniques intégrés dans le cadre et/ou dans le module photovoltaïque. Le fil de décadrage permet de décoller soigneusement le produit de scellage sans couper un ou des éléments de connexion.

Le fil de décadrage peut comporter au moins l'un des matériaux de la liste suivante, qui n'est pas limitative : polymère, nylon polyamide, métal, acier, aluminium.

Il peut être de section de forme choisie dans la liste suivante, qui n'est pas limitative : ronde, spiralée, polygonale, carrée.

Une plus grande dimension transversale du fil, par exemple son diamètre, peut être comprise entre 0,05 et 0,8 mm, notamment entre 0,1 et 0,6 mm, mieux entre 0,15 et 0,4 mm, étant notamment de l'ordre de 0,2 mm.

Le fil de décadrage peut être configuré pour supporter un poids de l'ordre de 2 à 4 kg.

Il peut avoir une résistance à la traction comprise entre 100 et 500kgf/mm², voire entre 120 et 400 kgf/mm², mieux entre 150 et 300 kgf/mm², étant notamment de l'ordre de 160 à 200 kgf/mm².

Le fil de décadrage peut être tendu sur la partie de cadre. Il peut être fixé par l'une ou les deux de ses extrémités libres sur le cadre, notamment sur une ou des parties de cadre. La fixation peut être effectuée à l'arrière de la partie de cadre, notamment de l'autre côté de la branche du E.

Le fil de décadrage peut s'étendre longitudinalement au bord du module photovoltaïque à proximité d'un bord du cadre, de manière à ce que le fil puisse venir découper un maximum de produit de scellage présent dans la gorge. Dans un mode de réalisation, le fil de décadrage peut s'étendre longitudinalement au bord du module photovoltaïque à une distance d d'un bord du cadre, la distance d pouvant être inférieure à 10 mm, voire inférieure à 8 mm, mieux inférieure à 5 mm, encore mieux inférieure à 4 mm.

Dans un mode de réalisation, le fil de décadrage peut s'étendre principalement sur une face avant du module photovoltaïque. En particulier, la rainure peut notamment être située du côté de la face avant du module photovoltaïque.

Le fil de décadrage peut s'étendre également minoritairement sur la face arrière du module photovoltaïque, étant notamment configuré pour passer sur la face arrière du module photovoltaïque.

Le fil de décadrage peut comporter une portion de fil s'étendant non parallèlement à la gorge du cadre, notamment perpendiculairement à la gorge du cadre, ladite portion de fil faisant le tour du module photovoltaïque pour passer de sa face avant à sa face arrière en passant par sa tranche.

Lorsque l'on vient tirer sur le fil de décadrage, cette configuration peut permettre le découpage du produit de scellage présent sur la face avant, la face arrière et la tranche du module photovoltaïque.

Le dispositif peut comporter des éléments électroniques intégrés, notamment dans le cadre et/ou dans le module photovoltaïque, et des éléments de connexion de ces éléments électroniques intégrés, notamment entre le module photovoltaïque et son cadre.

Les éléments électroniques peuvent par exemple être choisis dans la liste suivante, qui n'est pas limitative : diodes de by-pass, capteurs de condition environnementales, notamment de température et/ou d'hygrométrie, capteurs de production photovoltaïque, notamment de tension ou de courant, carte électronique, boîte de jonction, notamment dans le cadre ou en dehors.

Certains éléments électroniques peuvent être avantageusement placés dans le cadre, de manière à éviter de les placer à l'arrière du module photovoltaïque, par exemple boîte de jonction, carte électronique.

Les éléments de connexion peuvent par exemple être choisis dans la liste suivante, qui n'est pas limitative : ruban de jonction, fil de jonction. Les éléments de connexions peuvent être configurés pour permettre la connexion entre deux éléments électroniques intégrés, notamment entre le module photovoltaïque et son cadre, par exemple entre un élément électronique intégré dans le module photovoltaïque et un élément électronique intégré dans son cadre.

Le fil de décadrage peut comporter à l'une de ses extrémités libres, voire à chacune de ses extrémités libres, un organe de préhension du fil. Il peut s'agir d'une boucle du fil de décadrage.

L'organe de préhension du fil permet de tirer aisément sur celui-ci. Lorsque l'on tire sur le fil de décadrage, celui-ci découpe le produit de scellage. Cela peut permettre ensuite la séparation aisée du cadre et du module photovoltaïque.

L'organe de préhension du fil peut être situé sur la face arrière du module photovoltaïque.

Dans un mode de réalisation, le fil de décadrage peut comporter deux organes de préhension du fil, un à chacune de ses extrémités libres. Cela permet de tirer aisément sur le fil par l'une ou l'autre de ses extrémités libres, et notamment par les deux extrémités libres successivement, ce qui permet avantageusement de tirer presque toute la longueur du fil en évitant de tirer sur une partie centrale du fil. La partie centrale du fil sur laquelle on peut ne pas tirer peut être une partie du fil croisant un élément de connexion. Une telle configuration permet d'éviter de risque de tirer sur ledit élément de connexion et de l'endommager.

Lors de l'utilisation, on peut tirer sur une première extrémité libre du fil de décadrage jusqu'à l'élément de connexion, puis tirer sur la deuxième extrémité libre du fil de décadrage jusqu'à l'élément de connexion. Ainsi, on obtient que le fil de décadrage permette le décadrage du module photovoltaïque sur toute la longueur du fil, sauf au niveau de l'élément de connexion. Cela facilité la séparation complète du cadre et du module photovoltaïque, sans risquer d'endommager l'élément de connexion.

### Procédé de fabrication

Le fil de décadrage selon l'invention peut être mis en place dès la fabrication du dispositif photovoltaïque.

L'invention a ainsi pour objet, indépendamment ou en combinaison avec ce qui précède, un procédé de fabrication d'un dispositif photovoltaïque, notamment tel que défini ci-dessus,
le dispositif photovoltaïque comportant au moins un module photovoltaïque, comportant une face avant et une face arrière entre lesquelles est disposé un encapsulant de cellules photovoltaïques, et un cadre entourant le module photovoltaïque, le cadre comportant une gorge pour recevoir un bord du module photovoltaïque,
dans lequel on vient disposer un fil de décadrage dans la gorge du cadre de manière à ce que le fil de décadrage s'étende au moins en partie longitudinalement au bord du cadre, notamment dans une rainure du cadre.

Une fois effectué le montage du module photovoltaïque dans son cadre, le fil de décadrage est destiné à s'étendre au moins en partie longitudinalement au bord du module photovoltaïque.

On peut ensuite venir tendre puis fixer le fil de décadrage sur le cadre, de manière à éviter tout déplacement du fil de décadrage. On peut par exemple fixer les extrémités du fil de décadrage derrière le cadre, notamment en dehors de la gorge, du côté opposé à la rainure du cadre.

On peut ensuite venir noyer le fil de décadrage dans un produit de scellage, notamment du silicone. La gorge du cadre peut être remplie de produit de scellage.

On peut ensuite venir insérer le module photovoltaïque dans la gorge du cadre, notamment de façon qu'une portion de fil de décadrage soit disposée principalement sur une face avant du module photovoltaïque. Le fil de décadrage est maintenu en face avant du module photovoltaïque grâce à sa fixation au cadre. Il est empêché de se déplacer, et ne peut pas passer d'une face à l'autre.

On peut ensuite venir détacher une extrémité du fil de décadrage sur une portion de sa longueur, notamment d'environ 1 cm, afin de le disposer minoritairement sur la face arrière du module photovoltaïque, notamment en passant sur la face arrière du module photovoltaïque par sa tranche.

On peut enfin venir disposer une portion de fil de décadrage non parallèlement à la gorge du cadre, notamment perpendiculairement à la gorge du cadre, ladite portion de fil faisant le tour du module photovoltaïque pour passer de sa face avant à sa face arrière en passant par sa tranche.

Ainsi, le fil de décadrage s'étend minoritairement de manière non parallèle à la gorge du cadre, notamment perpendiculairement à la gorge du cadre, ladite portion de fil faisant le tour du module photovoltaïque pour passer de sa face avant à sa face arrière en passant par sa tranche.

On peut ensuite venir fixer l'extrémité du fil de décadrage qui avait été détachée sur la face arrière du module photovoltaïque, au plus près du cadre.

L'opération peut être effectué une seule fois, ou plusieurs fois, notamment deux, trois ou quatre fois, dépendant notamment du nombre de fils de décadrage du dispositif et/ou du nombre de parties de cadre du dispositif.

Dans le mode de réalisation qui vient d'être décrit, on dispose le fil de décadrage dans le cadre avant d'insérer le module photovoltaïque dans le cadre.

En variante, on peut disposer le fil de décadrage sur le module photovoltaïque, puis on insère le module photovoltaïque portant le fil de décadrage dans le cadre.

Dans une première étape, on vient fixer le fil de décadrage sur la face avant du module photovoltaïque, par exemple par un adhésif, collage ou autre, notamment sur tout son contour. Le fil de décadrage peut être tendu sur le module photovoltaïque. Une portion du fil de décadrage peut être placée de manière à faire le tour du module photovoltaïque pour passer de sa face avant à sa face arrière en passant par sa tranche. Il peut faire presque tout le tour de la face avant du module photovoltaïque, sauf la portion placée de manière à faire le tour du module photovoltaïque pour passer de sa face avant à sa face arrière en passant par sa tranche. Ladite portion peut être de 1 cm à 2 cm environ.

Dans une deuxième étape, on vient insérer le module photovoltaïque portant le fil de décadrage dans le cadre, en laissant le fil de décadrage dans la gorge du cadre et en laissant la portion du fil de décadrage ressortir par la face arrière du module photovoltaïque.

Dans tous les modes de réalisation, la pose du fil de décadrage peut être effectuée manuellement par tension sur le cadre ou sur le module photovoltaïque ou industriellement.

### Procédé de démontage

L'invention a encore pour objet, indépendamment ou en combinaison avec ce qui précède, un procédé de démontage d'un dispositif photovoltaïque tel que défini plus haut, dans lequel on vient tirer sur le fil de décadrage, notamment à l'une ou les deux de ses extrémités libres, notamment depuis la face arrière du module photovoltaïque.

Le fait de tirer sur le fil de décadrage permet de fragiliser un produit de scellage présent dans la gorge du cadre, pour y maintenir le module photovoltaïque. Le dispositif photovoltaïque peut comporter un produite de scellage tout autour du module photovoltaïque.

En tirant sur le fil de décadrage depuis la face arrière du module photovoltaïque, en tirant dans la direction de l'arrivée du fil de décadrage, le fil de décadrage vient découper le produit de scellage présent, d'abord sur la face arrière, puis sur la tranche, puis sur la face avant du module photovoltaïque.

On peut tirer sur le fil de décadrage de manière manuelle, ou avec un outil, par exemple un crochet relié à un treuil à force monitorée.

On peut ensuite venir tirer sur le fil de décadrage parallèlement à un bord du module photovoltaïque. On vient notamment tirer sur le fil de décadrage parallèlement à la gorge du cadre dans laquelle est reçu le fil de décadrage.

On obtient un découpage d'un produit de scellage du module photovoltaïque dans son cadre, et ainsi la séparation du module photovoltaïque de son cadre. On peut obtenir le découpage du produit de scellage sur les faces avant et arrière du module photovoltaïque simultanément.

On peut venir tirer sur une première extrémité libre du fil de décadrage jusqu'à un élément de connexion, puis on vient tirer sur une deuxième extrémité libre du fil de décadrage jusqu'à l'élément de connexion.

On peut notamment tirer le fil de décadrage par les deux extrémités libres successivement, ce qui permet avantageusement de tirer presque toute la longueur du fil en évitant de tirer sur une partie centrale du fil. La partie centrale du fil sur laquelle on peut ne pas tirer peut être une partie du fil croisant un élément de connexion. Une telle configuration permet d'éviter de risque de tirer sur ledit élément de connexion et de l'endommager.

Lors du démontage, on peut ainsi tirer sur une première extrémité libre du fil de décadrage jusqu'à l'élément de connexion, puis tirer sur la deuxième extrémité libre du fil de décadrage jusqu'à l'élément de connexion. Ainsi, on obtient que le fil de décadrage permette le décadrage du module photovoltaïque sur toute la longueur du fil, sauf au niveau de l'élément de connexion. Cela facilité la séparation complète du cadre et du module photovoltaïque, sans risquer d'endommager l'élément de connexion.

Une fois que l'on a tiré sur le fil de décdarge, on peut venir dessouder le ou les élément de connexion.

L'invention a encore pour objet, indépendamment ou en combinaison avec ce qui précède, un procédé de recyclage d'un dispositif photovoltaïque, notamment tel que défini plus haut, comportant la mise en œuvre du procédé de démontage d'un dispositif photovoltaïque tel que décrit ci-dessus pour désassembler le module photovoltaïque du cadre.

L'invention a encore pour objet, indépendamment ou en combinaison avec ce qui précède, une installation de traitement pour démontage d'un dispositif photovoltaïque, notamment tel que défini plus haut, le module photovoltaïque du dispositif photovoltaïque pouvant comporter au moins une cellule photovoltaïque, notamment pour la mise en œuvre du procédé tel que décrit ci-dessus.

### Brève description des dessins

L'invention pourra être mieux comprise à la lecture de la description détaillée qui va suivre, d'exemples de réalisation non limitatifs de celle-ci, et à l'examen du dessin annexé, sur lequel :
[Fig 1] La figure 1 est une vue en perspective, schématique et partielle, d'un module photovoltaïque.
[Fig 2] La figure 2 est une vue en coupe, schématique et partielle, du module photovoltaïque de la figure 1.
[Fig 3] La figure 3 est une vue en coupe et en perspective, schématique et partielle, d'un dispositif photovoltaïque selon l'invention.
[Fig 4] La figure 4 est une vue en coupe et en perspective, et de dessus, schématique et partielle, du procédé de fabrication du dispositif photovoltaïque de la figure 3.
[Fig 5] La figure 5 est une vue en coupe et en perspective, schématique et partielle, d'une étape de ce procédé de fabrication.
[Fig 6] La figure 6 est une vue de dessus, schématique et partielle, d'une variante de réalisation du procédé de fabrication du dispositif photovoltaïque de la figure 3.
[Fig 7] La figure 7 est une vue en coupe et en perspective, schématique et partielle, d'une étape du procédé de démontage.
[Fig 8] La figure 8 est une vue en coupe et en perspective, schématique et partielle, d'une étape du procédé de démontage.
[Fig 9] La figure 9 est une vue de dessus, schématique et partielle, du procédé de démontage de la figure 8.

### Description détaillée

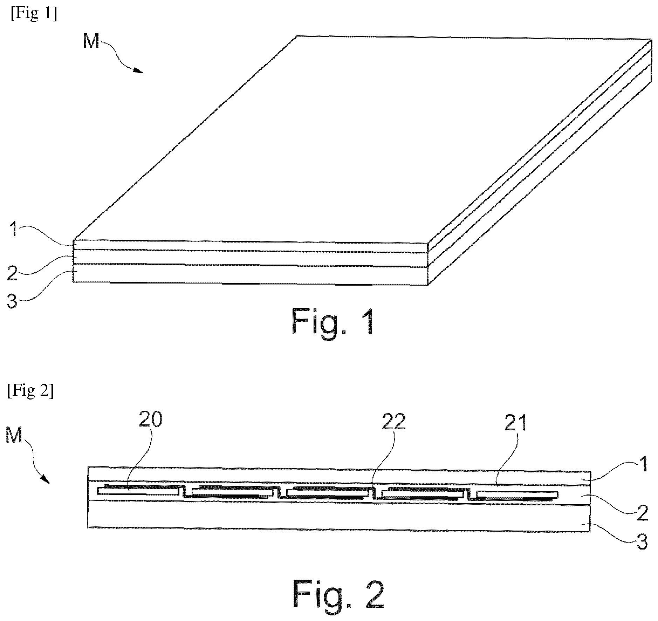

On a illustré aux figures 1 et 2 un module photovoltaïque M comportant plusieurs couches superposées et assemblées entre elles :
- Une première couche de protection 1 (appelée couramment *"backsheet*") en face arrière ; cette première couche de protection 1 est habituellement réalisée à base de polymères multi-couches ; elle peut être opaque ou transparente, monocouche ou multicouche ;
- Une deuxième couche 2, dite couche intermédiaire, intercalée entre la première couche et la troisième couche 3, décrite ci-dessous, permettant l'assemblage d'un côté de la première couche de protection 1 et de l'autre côté de la troisième couche de protection 3 ; cette couche intermédiaire comportant des cellules photovoltaïques 20, la connectique électrique 22 et un encapsulant 21 arrangé autour des cellules photovoltaïques ;
- Une troisième couche de protection 3 en face avant ; cette troisième couche de protection 3 est habituellement en verre, par exemple en verre trempé transparent d' épaisseur d'environ 3 à 4 mm. Elle peut en variante être à base de polymères multi-couches définissant une face arrière non transparente, dite *« backsheet ».*

Dans la suite de la description, la face avant du module photovoltaïque M correspond à une face du module recevant les rayons lumineux et la face arrière correspond à la face opposée à la face avant. Les deux couches de protection 1 et 3 peuvent présenter une fonction de rigidification et/ou une fonction de protection de surface.

La première couche 1 peut notamment assurer une fonction d'imperméabilité aux gaz et à l'eau, une fonction de protection/isolation électrique et une fonction de protection mécanique. Cette première couche 1 peut être réalisée à base d'un polymère fluoré. Il peut s'agir du polyfluorure de vinyle (PVF), par exemple commercialisé sous le nom TEDLAR (marque déposée) par la société DuPont (marque déposée). De manière non limitative, la première couche 1 peut elle-même être composée d'un empilement de plusieurs strates : une strate de PVF, une strate en PET (poly(téréphtalate) d'éthylène), une strate de PVF.

Dans la couche intermédiaire 2, l'encapsulant 21 est classiquement réalisé dans un matériau polymère, par exemple de type élastomère transparent, dans lequel est encapsulé ou enrobé au moins un élément électriquement ou optiquement actif, tels que des cellules photovoltaïques. Il peut s'agir d'un polymère tel que de l'EVA (Ethylène-Acétate de Vinyl) formant un matériau sur lequel peuvent adhérer la première couche 1 d'un côté et la troisième couche 3 de l'autre côté et permettre l'assemblage des trois couches entre elles. Les trois couches peuvent être assemblées entre elles par laminage à chaud, de sorte que la première couche et la troisième couche viennent adhérer au matériau de l'encapsulant 21, formant ainsi un empilement monobloc.

Dans la couche intermédiaire 2, les cellules photovoltaïques 20 sont connectées entre elles, en série/parallèle, formant plusieurs chaînes (*"string"* en anglais) de cellules. Des éléments de connexion électrique 22, par exemple en cuivre, permettent d'assurer les liaisons électriques entre les cellules 20 dans chaque chaîne.

On peut définir des bords 40 du module photovoltaïque M, qui définissent son pourtour, étant formés par les bords des face avant 41 et face arrière 42 et de l'encapsulant. On peut définir deux bords opposés, le module photovoltaïque ayant une forme générale rectangulaire. Les bords 40 du module photovoltaïque M peuvent avoir une certaine épaisseur, du fait de la présence des cellules photovoltaïques dans l'encapsulant, de sorte qu'on peut définir des arêtes des bords au niveau des arrêtes supérieure et inférieures, de part et d'autre de la tranche du module photovoltaïque M.

Le module photovoltaïque M est entouré d'un cadre 30, par exemple en aluminium, agencé en périphérie de l'empilement pour rigidifier le module photovoltaïque M, formant ainsi un dispositif photovoltaïque 100. Le dispositif photovoltaïque 100 peut également comporter une boîte de jonction électrique (non représentée) généralement fixée sur la face arrière du module M.

Le cadre 30 peut comporter une ou plusieurs parties de cadre, par exemple une, deux, trois ou quatre parties de cadre. Une partie de cadre peut protéger le module photovoltaïque sur un ou plusieurs de ses bords, notamment un seul bord ou deux bords adjacents.

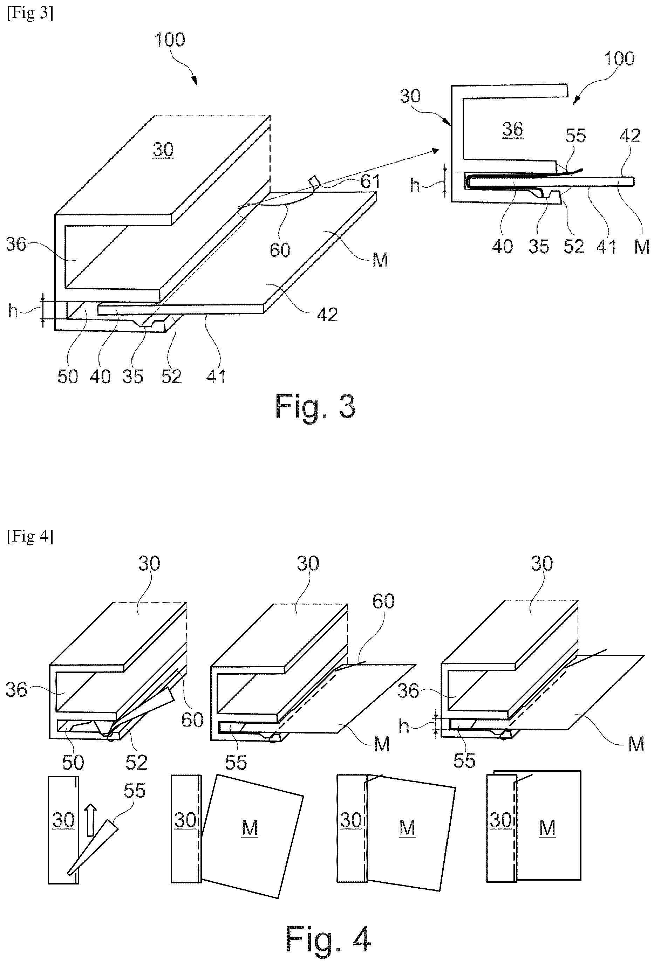

Le cadre 30 comporte une gorge 50 pour recevoir un bord 40 du module photovoltaïque, comme illustré à la figure 3.

La gorge 50 reçoit également un produit de scellage 55, par exemple du silicone, dans lequel est noyé le bord 40 du module photovoltaïque M, comme illustré à la figure 4. La gorge 50 peut être remplie de produit de scellage 55.

Une hauteur h de la gorge 50 peut être configurée pour permettre au cadre de recevoir suffisamment de produit de scellage 55 afin d'assurer une bonne étanchéité et le collage du module photovoltaïque M dans le cadre 30. La hauteur h de la gorge 50 peut être comprise entre 2 et 6 mm.

Le cadre 30 comporte également, lorsqu'observé en section transversale, une cannelure 36, laquelle s'étend parallèlement à la gorge 50 recevant le bord 40 du module photovoltaïque M. La cannelure 36 peut être utilisée pour la fixation du cadre sur un support de cadre par exemple, notamment par boulonnage.

Ainsi, le cadre 30 a, lorsqu'observé en section transversale, une forme générale de E, ce qui permet d'améliorer sa rigidité. L'une au moins des branches du E, notamment une branche entourant la gorge 50 recevant un bord 40 du module photovoltaïque M, est chanfreinée en un chanfrein 52. Le chanfrein 52 peut permettre de faciliter l'insertion du produit de scellage dans la gorge 50 et/ou du bord 40 du module photovoltaïque M.

Par ailleurs, le cadre 30 comporte une rainure longitudinale 35 pour recevoir un fil de décadrage 60, s'étendant notamment parallèlement à la gorge 40 du cadre 30. La rainure longitudinale est ménagée dans la gorge 50 du cadre 30, étant située sur l'une des branches du E entourant la gorge 50 recevant le bord 40 du module photovoltaïque M, en particulier la branche située du côté de la face avant 41 du module photovoltaïque. La rainure longitudinale est située sur l'une des branches du E, du côté intérieur de la gorge 50. Elle permet de bien caler le fil de décadrage 60 et de le maintenir en position.

Ainsi, le dispositif photovoltaïque 100 comporte un ou plusieurs fils de décadrage 60 disposés dans la gorge 50, s'étendant au moins en partie longitudinalement au bord 40 du module photovoltaïque M. Dans l'exemple décrit, on voit un unique fil de décadrage 60 disposé le long d'un des bords 40 du module photovoltaïque M.

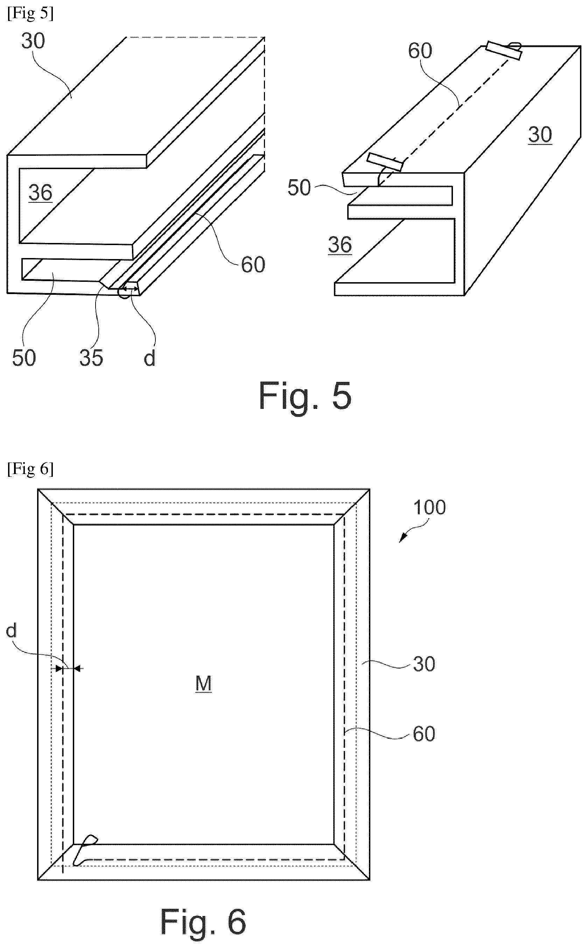

Le fil de décadrage 60 est tendu sur la partie de cadre, comme visible sur la figure 5. Il est fixé par ses deux extrémités libres sur le cadre. La fixation est ici effectuée à l'arrière de la partie de cadre, de l'autre côté de la branche du E du cadre 30.

Dans un mode de réalisation, le dispositif comporte un unique fil de décadrage 60, lequel peut être disposé le long de tous les bords 40 du module photovoltaïque, comme on le verra plus loin en référence à la figure 6.

Le fil de décadrage 60 peut s'étendre longitudinalement au bord du module photovoltaïque à une distance d d'un bord du cadre, la distance d pouvant être inférieure à 8 mm. La profondeur de la gorge peut être de l'ordre de 10 mm.

Un espace restant entre les parois de la gorge 50 et les faces 41, 42 du module photovoltaïque M détermine le diamètre maximal du fil de décadrage 60 utilisable. Le jeu moyen peut être d'environ 200 µm. Un diamètre maximal du fil de décadrage peut être compris entre 150 et 250 µm. A titre d'exemple, on peut utiliser un fil de nylon de 200 µm de diamètre.

Le fil de décadrage 60 s'étend principalement sur la face avant 41 du module photovoltaïque M, la rainure 35 étant située du côté de la face avant 41 du module photovoltaïque M. En outre, le fil de décadrage 60 s'étend également minoritairement sur la face arrière 42 du module photovoltaïque M, étant configuré pour passer sur la face arrière du module photovoltaïque. A cet effet, le fil de décadrage 60 comporte une portion de fil s'étendant perpendiculairement à la gorge 50 du cadre 30, ladite portion de fil faisant le tour du module photovoltaïque M pour passer de sa face avant 41 à sa face arrière 42 en passant par sa tranche, comme illustré sur la figure 3.

Lorsque l'on vient tirer sur le fil de décadrage, cette configuration permet le découpage du produit de scellage 55 présent sur la face avant 41, la face arrière 42 et la tranche du module photovoltaïque M.

Le fil de décadrage 60 comporte à l'une de ses extrémités libres, voire à chacune de ses extrémités libres, un organe de préhension 61 du fil de décadrage 60. Il s'agit dans cet exemple d'une boucle du fil de décadrage 60. L'organe de préhension du fil est situé sur la face arrière 42 du module photovoltaïque. L'organe de préhension 61 du fil de décadrage 60 permet de tirer aisément sur celui-ci. Lorsque l'on tire sur le fil de décadrage 60, celui-ci découpe le produit de scellage 55. Cela peut permettre ensuite la séparation aisée du cadre 30 et du module photovoltaïque M.

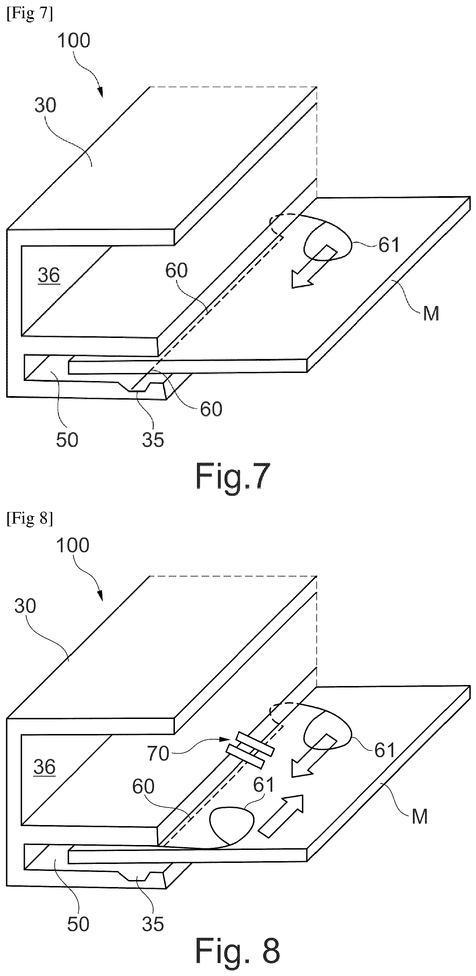

Dans un mode de réalisation illustré à la figure 8, le dispositif photovoltaïque 100 comporte des éléments électroniques intégrés, dans le cadre et/ou dans le module photovoltaïque, et des éléments de connexion 70 de ces éléments électroniques intégrés, notamment entre le module photovoltaïque M et son cadre 30, afin de permettre la connexion entre deux éléments électroniques intégrés, par exemple entre un élément électronique intégré dans le module photovoltaïque et un élément électronique intégré dans son cadre.

Dans ce cas notamment, le fil de décadrage 60 comporte deux organe de préhension 61 du fil, un à chacune de ses extrémités libres. Cela permet de tirer aisément sur le fil par l'une ou l'autre de ses extrémités libres, et notamment par les deux extrémités libres successivement, ce qui permet avantageusement de tirer presque toute la longueur du fil en évitant de tirer sur une partie centrale du fil. La partie centrale du fil sur laquelle on peut ne pas tirer est une partie du fil croisant un élément de connexion 70. Une telle configuration permet d'éviter de risque de tirer sur ledit élément de connexion et de l'endommager.

Le fil de décadrage selon l'invention peut être mis en place dès la fabrication du dispositif photovoltaïque. On va maintenant décrire, en référence à la figure 4, un procédé de fabrication du dispositif photovoltaïque 100.

Dans une première étape illustrée à la figure 4, on vient disposer le fil de décadrage 60 dans la gorge 50 du cadre de manière à ce que le fil de décadrage s'étende au moins en partie longitudinalement au bord du cadre 30, dans la rainure 35 du cadre.

On vient ensuite tendre puis fixer le fil de décadrage 60 sur le cadre 30, de manière à éviter tout déplacement du fil de décadrage.

On vient ensuite noyer le fil de décadrage 60 dans un produit de scellage 55, notamment du silicone. La gorge du cadre peut être remplie de produit de scellage 55.

On vient ensuite insérer le module photovoltaïque M dans la gorge 50 du cadre 30, de façon qu'une portion de fil de décadrage 60 soit disposée principalement sur une face avant 41 du module photovoltaïque M, comme visible en pointillés sur la figure 4.

On vient ensuite détacher une extrémité du fil de décadrage sur une portion de sa longueur, d'environ 1 cm, afin de le disposer minoritairement sur la face arrière 42 du module photovoltaïque M, en passant sur la face arrière 42 du module photovoltaïque par sa tranche. On vient à cet effet disposer une portion de fil de décadrage 60 perpendiculairement à la gorge 50 du cadre 30, ladite portion de fil faisant le tour du module photovoltaïque pour passer de sa face avant 41 à sa face arrière 42 en passant par sa tranche.

On vient ensuite fixer l'extrémité du fil de décadrage qui avait été détachée sur la face arrière du module photovoltaïque, au plus près du cadre.

Dans le mode de réalisation qui vient d'être décrit, on dispose le fil de décadrage dans le cadre avant d'insérer le module photovoltaïque dans le cadre.

En variante, on peut disposer le fil de décadrage sur le module photovoltaïque, puis on insère le module photovoltaïque portant le fil de décadrage dans le cadre, comme illustré à la figure 6.

Dans une première étape, on vient fixer le fil de décadrage 60 sur la face avant 41 du module photovoltaïque, sur tout son contour. Le fil de décadrage peut être tendu sur le module photovoltaïque. Une portion du fil de décadrage 60 peut être placée de manière à faire le tour du module photovoltaïque pour passer de sa face avant 41 à sa face arrière 42 en passant par sa tranche. Il peut faire presque tout le tour de la face avant 41 du module photovoltaïque M, comme indiqué en pointillé sur la figure 6, sauf la portion placée de manière à faire le tour du module photovoltaïque pour passer de sa face avant 41 à sa face arrière 42 en passant par sa tranche. Ladite portion peut être de 1 cm à 2 cm environ.

Dans une deuxième étape, on vient insérer le module photovoltaïque M portant le fil de décadrage 60 dans le cadre 30, en laissant le fil de décadrage 60 dans la gorge 50 du cadre 30 et en laissant la portion du fil de décadrage 60 ressortir par la face arrière 42 du module photovoltaïque M.

Le ou les fils de décadrage 60 sont configurés pour permettre la découpe du produit de scellage du module photovoltaïque M dans son cadre 30, et ainsi de séparer le module photovoltaïque M de son cadre 30. Le dispositif photovoltaïque 100 peut être démonté de manière aisée par fragilisation du produit de scellage 55, comme explicité ci-après en référence à la figure 7.

Pour procéder au démontage du dispositif photovoltaïque 100, on vient tirer sur le fil de décadrage 60, par l'une ou les deux de ses extrémités libres, depuis la face arrière 42 du module photovoltaïque M. Le fait de tirer sur le fil de décadrage 60 permet de fragiliser le produit de scellage 55. En tirant sur le fil de décadrage depuis la face arrière du module photovoltaïque, en tirant dans la direction de l'arrivée du fil de décadrage, le fil de décadrage 60 vient découper le produit de scellage 55 présent, d'abord sur la face arrière 42, puis sur la tranche, puis sur la face avant 41 du module photovoltaïque M. On vient tirer sur le fil de décadrage parallèlement au bord 40 du module photovoltaïque M, et parallèlement à la gorge 50 du cadre dans laquelle est reçu le fil de décadrage 60.

On obtient un découpage du produit de scellage 55 du module photovoltaïque dans son cadre, et ainsi la séparation du module photovoltaïque M de son cadre 30.

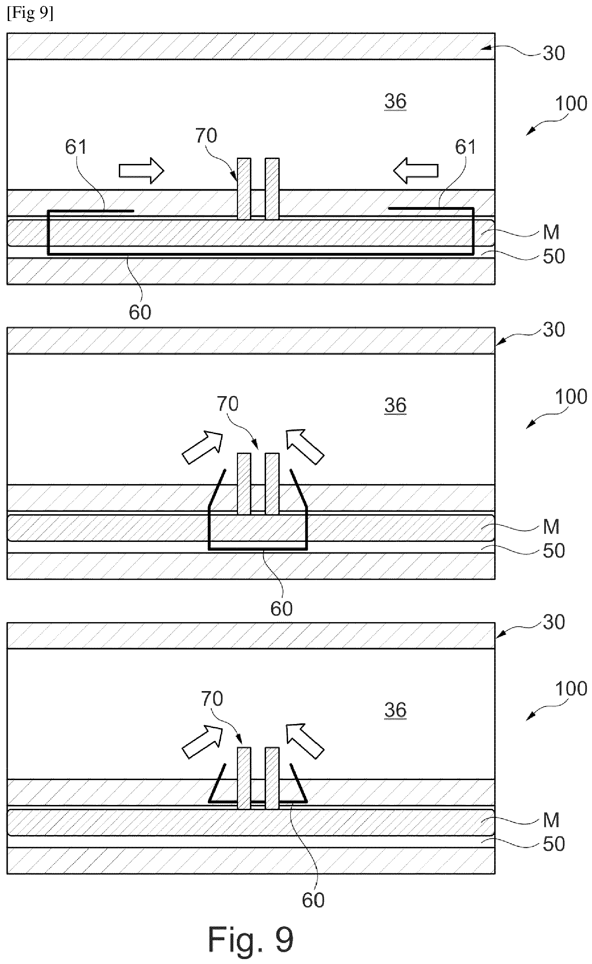

Dans le cas où le dispositif photovoltaïque comporte un ou des éléments de connexion 70, comme illustré en référence aux figures 8 et 9, on vient tirer sur une première extrémité libre du fil de décadrage 60 jusqu'à l'élément de connexion 70, puis on vient tirer sur une deuxième extrémité libre du fil de décadrage 60 jusqu'à l'élément de connexion 70. Cela permet avantageusement de tirer presque toute la longueur du fil en évitant de tirer sur une partie centrale du fil, qui croise l'élément de connexion 70. Ainsi, on évite de risquer de tirer sur ledit élément de connexion 70 et de l'endommager.

Une fois que l'on a tiré sur le fil de décadrage 60, on peut venir dessouder le ou les élément de connexion 70.

## Revendications

1. Dispositif photovoltaïque (100), comportant :
- au moins un module photovoltaïque (M), comportant une face avant (41) et une face arrière (42) entre lesquelles est disposé un encapsulant de cellules photovoltaïques, et
- un cadre (30) entourant le module photovoltaïque (M), le cadre (30) comportant une gorge (50) pour recevoir un bord (40) du module photovoltaïque (M), **caractérisé en ce que** le dispositif photovoltaïque comporte
un ou plusieurs fils de décadrage (60) disposés dans la gorge (50), s'étendant au moins en partie longitudinalement au bord (40) du module photovoltaïque (M).

2. Dispositif photovoltaïque selon la revendication précédente, le cadre (30) comportant une rainure longitudinale (35) pour recevoir le fil de décadrage (60), s'étendant notamment parallèlement à la gorge (50) du cadre (30).

3. Dispositif photovoltaïque selon l'une des revendications précédentes, le fil de décadrage (60) s'étendant principalement sur une face avant (41) du module photovoltaïque (M).

4. Dispositif photovoltaïque selon la revendication précédente, le fil de décadrage (60) s'étendant également minoritairement sur la face arrière (42) du module photovoltaïque (M), étant notamment configuré pour passer sur la face arrière (42) du module photovoltaïque (M).

5. Dispositif photovoltaïque selon la revendication précédente, le fil de décadrage (60) comportant une portion de fil s'étendant non parallèlement à la gorge (50) du cadre (30), notamment perpendiculairement à la gorge (50) du cadre (30), ladite portion de fil (60) faisant le tour du module photovoltaïque (M) pour passer de sa face avant (41) à sa face arrière (42) en passant par sa tranche.

6. Dispositif photovoltaïque selon l'une des revendications précédentes, comportant des éléments électroniques intégrés, notamment dans le cadre (30) et/ou dans le module photovoltaïque (M), et des éléments de connexion (70) de ces éléments électroniques intégrés, notamment entre le module photovoltaïque (M) et son cadre (30).

7. Dispositif photovoltaïque selon l'une des revendications précédentes, le fil de décadrage (60) comportant à l'une de ses extrémités libres, voire à chacune de ses extrémités libres, un organe de préhension (61) du fil.

8. Dispositif photovoltaïque selon l'une des revendications précédentes, le fil de décadrage (60) comportant deux organes de préhension du fil (61), un à chacune de ses extrémités libres.

9. Procédé de fabrication d'un dispositif photovoltaïque (100) selon l'une quelconque des revendications précédentes,
le dispositif photovoltaïque (100) comportant au moins un module photovoltaïque (M), comportant une face avant (41) et une face arrière (42) entre lesquelles est disposé un encapsulant de cellules photovoltaïques, et un cadre (30) entourant le module photovoltaïque (M), le cadre (30) comportant une gorge (50) pour recevoir un bord (40) du module photovoltaïque (M),
procédé dans lequel on vient disposer un fil de décadrage (60) dans la gorge (50) du cadre (30) de manière à ce que le fil de décadrage (60) s'étende au moins en partie longitudinalement au bord du cadre (30), notamment dans une rainure (35) du cadre (30).

10. Procédé de fabrication selon la revendication précédente, dans lequel on vient ensuite noyer le fil de décadrage (60) dans un produit de scellage (55), notamment du silicone.

11. Procédé de fabrication selon la revendication précédente, dans lequel on vient ensuite insérer le module photovoltaïque (M) dans la gorge (50) du cadre (30), notamment de façon qu'une portion de fil de décadrage soit disposée principalement sur une face avant (41) du module photovoltaïque (M).

12. Procédé de fabrication selon la revendication précédente, dans lequel on vient ensuite détacher une extrémité du fil de décadrage (60) sur une portion de sa longueur, notamment d'environ 1 cm, afin de le disposer minoritairement sur la face arrière (42) du module photovoltaïque (M), notamment en passant sur la face arrière (42) du module photovoltaïque par sa tranche (M).

13. Procédé de fabrication selon la revendication précédente dans lequel on vient disposer une portion de fil de décadrage (60) non parallèlement à la gorge (50) du cadre (30), notamment perpendiculairement à la gorge du cadre, ladite portion de fil faisant le tour du module photovoltaïque (M) pour passer de sa face avant (41) à sa face arrière (42) en passant par sa tranche.

14. Procédé de démontage d'un dispositif photovoltaïque selon l'une quelconque des revendications 1 à 8,
dans lequel on vient tirer sur le fil de décadrage (60), notamment à l'une ou les deux de ses extrémités libres, notamment depuis la face arrière (42) du module photovoltaïque (M).

15. Procédé de démontage selon la revendication précédente, dans lequel on vient tirer sur le fil de décadrage (60) parallèlement à un bord (40) du module photovoltaïque (M).

16. Procédé de démontage selon l'une des deux revendications précédentes, dans lequel on vient tirer sur une première extrémité libre du fil de décadrage (60) jusqu'à un élément de connexion (70), puis on vient tirer sur une deuxième extrémité libre du fil de décadrage jusqu'à l'élément de connexion (70).

## Patentansprüche

1. Photovoltaikvorrichtung (100), umfassend:
- mindestens ein Photovoltaikmodul (M), das eine Vorderseite (41) und eine Rückseite (42) umfasst, zwischen denen ein Photovoltaikzellen-Verkapselungsmaterial angeordnet ist, und
- einen Rahmen (30), der das Photovoltaikmodul (M) umgibt, wobei der Rahmen (30) eine Nut (50) zum Aufnehmen einer Kante (40) des Photovoltaikmoduls (M) umfasst, **dadurch gekennzeichnet, dass** die Photovoltaikvorrichtung einen oder mehrere Entrahmungsfäden (60) umfasst, die in der Nut (50) angeordnet sind und sich mindestens teilweise längs zu der Kante (40) des Photovoltaikmoduls (M) erstrecken.

2. Photovoltaikvorrichtung nach dem vorhergehenden Anspruch, wobei der Rahmen (30) eine Längsrille (35) zum Aufnehmen des Entrahmungsfadens (60) umfasst, die sich insbesondere parallel zu der Nut (50) des Rahmens (30) erstreckt.

3. Photovoltaikvorrichtung nach einem der vorhergehenden Ansprüche, wobei sich der Entrahmungsfaden (60) hauptsächlich auf einer Vorderseite (41) des Photovoltaikmoduls (M) erstreckt.

4. Photovoltaikvorrichtung nach dem vorhergehenden Anspruch, wobei sich der Entrahmungsfaden (60) zu einem geringeren Anteil auch auf der Rückseite (42) des Photovoltaikmoduls (M) erstreckt, wobei er insbesondere dazu ausgelegt ist, auf der Rückseite (42) des Photovoltaikmoduls (M) zu verlaufen.

5. Photovoltaikvorrichtung nach dem vorhergehenden Anspruch, wobei der Entrahmungsfaden (60) einen Fadenabschnitt umfasst, der sich nicht parallel zu der Nut (50) des Rahmens (30), insbesondere senkrecht zu der Nut (50) des Rahmens (30), erstreckt, wobei der Fadenabschnitt (60) um das Photovoltaikmodul (M) herumläuft, um von seiner Vorderseite (41) über seine Schmalseite zu seiner Rückseite (42) zu verlaufen.

6. Photovoltaikvorrichtung nach einem der vorhergehenden Ansprüche, umfassend integrierte elektronische Elemente, insbesondere in dem Rahmen (30) und/oder in dem Photovoltaikmodul (M), und Anschlusselemente (70) für diese integrierten elektronischen Elemente, insbesondere zwischen dem Photovoltaikmodul (M) und seinem Rahmen (30).

7. Photovoltaikvorrichtung nach einem der vorhergehenden Ansprüche, wobei der Entrahmungsfaden (60) an einem seiner freien Enden oder sogar an jedem seiner freien Enden ein Fadengreiforgan (61) umfasst.

8. Photovoltaikvorrichtung nach einem der vorhergehenden Ansprüche, wobei der Entrahmungsfaden (60) zwei Fadengreiforgane (61) umfasst, eines an jedem seiner freien Enden.

9. Verfahren zur Herstellung einer Photovoltaikvorrichtung (100) nach einem der vorhergehenden Ansprüche,
wobei die Photovoltaikvorrichtung (100) mindestens ein Photovoltaikmodul (M), das eine Vorderseite (41) und eine Rückseite (42) umfasst, zwischen denen ein Photovoltaikzellen-Verkapselungsmaterial angeordnet ist, und einen Rahmen (30), der das Photovoltaikmodul (M) umgibt, umfasst, wobei der Rahmen (30) eine Nut (50) zum Aufnehmen einer Kante (40) des Photovoltaikmoduls (M) umfasst,
wobei bei dem Verfahren ein Entrahmungsfaden (60) so in der Nut (50) des Rahmens (30) angeordnet wird, dass sich der Entrahmungsfaden (60) mindestens teilweise längs zu der Kante des Rahmens (30), insbesondere in einer Rille (35) des Rahmens (30), erstreckt.

10. Verfahren zur Herstellung nach dem vorhergehenden Anspruch, bei dem der Entrahmungsfaden (60) anschließend in ein Versiegelungsprodukt (55), insbesondere Silikon, eingebettet wird.

11. Verfahren zur Herstellung nach dem vorhergehenden Anspruch, bei dem das Photovoltaikmodul (M) anschließend in die Nut (50) des Rahmens (30) eingesetzt wird, insbesondere derart, dass ein Abschnitt des Entrahmungsfadens hauptsächlich auf einer Vorderseite (41) des Photovoltaikmoduls (M) angeordnet ist.

12. Verfahren zur Herstellung nach dem vorhergehenden Anspruch, bei dem anschließend ein Ende des Entrahmungsfadens (60) über einen Abschnitt seiner Länge, insbesondere etwa 1 cm, gelöst wird, um ihn zu einem geringeren Anteil auf der Rückseite (42) des Photovoltaikmoduls (M) anzuordnen, wobei er insbesondere über dessen Schmalseite (M) auf der Rückseite (42) des Photovoltaikmoduls verläuft.

13. Verfahren zur Herstellung nach dem vorhergehenden Anspruch, bei dem ein Abschnitt des Entrahmungsfadens (60) nicht parallel zu der Nut (50) des Rahmens (30), insbesondere senkrecht zu der Nut des Rahmens, angeordnet wird, wobei der Fadenabschnitt um das Photovoltaikmodul (M) herumläuft, um von seiner Vorderseite (41) über seine Schmalseite zu seiner Rückseite (42) zu verlaufen.

14. Verfahren zur Demontage einer Photovoltaikvorrichtung nach einem der Ansprüche 1 bis 8,
bei dem an dem Entrahmungsfaden (60), insbesondere an einem oder beiden seiner freien Enden, insbesondere von der Rückseite (42) des Photovoltaikmoduls (M) aus, gezogen wird.

15. Verfahren zur Demontage nach dem vorhergehenden Anspruch, bei dem an dem Entrahmungsfaden (60) parallel zu einer Kante (40) des Photovoltaikmoduls (M) gezogen wird.

16. Verfahren zur Demontage nach einem der beiden vorhergehenden Ansprüche, bei dem an einem ersten freien Ende des Entrahmungsfadens (60) bis zu einem Anschlusselement (70) gezogen wird, dann an einem zweiten freien Ende des Entrahmungsfadens bis zu dem Anschlusselement (70) gezogen wird.

## Claims

1. Photovoltaic device (100), including:
- at least one photovoltaic module (M), including a front face (41) and a rear face (42) between which a photovoltaic cell encapsulant is arranged, and
- a frame (30) surrounding the photovoltaic module (M), the frame (30) including a groove (50) for receiving an edge (40) of the photovoltaic module (M), **characterized in that** the photovoltaic device includes one or more separation wires (60) arranged in the groove (50), extending at least partially longitudinally along the edge (40) of the photovoltaic module (M).

2. Photovoltaic device according to the preceding claim, the frame (30) including a longitudinal slot (35) for receiving the separation wire (60), extending in particular parallel to the groove (50) of the frame (30).

3. Photovoltaic device according to one of the preceding claims, the separation wire (60) extending mainly over a front face (41) of the photovoltaic module (M) .

4. Photovoltaic device according to the preceding claim, the separation wire (60) also extending to a lesser extent over the rear face (42) of the photovoltaic module (M), in particular being configured to pass over the rear face (42) of the photovoltaic module (M).

5. Photovoltaic device according to the preceding claim, the separation wire (60) including a wire portion extending non-parallel to the groove (50) of the frame (30), in particular perpendicularly to the groove (50) of the frame (30), said portion of wire (60) being passed about the photovoltaic module (M) from the front face (41) to the rear face (42) via the edge face thereof.

6. Photovoltaic device according to one of the preceding claims, including integrated electronic elements, in particular in the frame (30) and/or in the photovoltaic module (M), and connecting elements (70) for these integrated electronic elements, in particular between the photovoltaic module (M) and the frame (30) thereof.

7. Photovoltaic device according to one of the preceding claims, the separation wire (60) including, at one of the free ends thereof, or at each of the free ends thereof, a wire gripping member (61).

8. Photovoltaic device according to one of the preceding claims, the separation wire (60) including two wire gripping members (61), one at each of the free ends thereof.

9. Method for manufacturing a photovoltaic device (100) according to any one of the preceding claims,
the photovoltaic device (100) including at least one photovoltaic module (M), including a front face (41) and a rear face (42) between which a photovoltaic cell encapsulant is arranged, and a frame (30) surrounding the photovoltaic module (M), the frame (30) including a groove (50) for receiving an edge (40) of the photovoltaic module (M),
in which method a separation wire (60) is arranged in the groove (50) of the frame (30) so that the separation wire (60) extends at least in part longitudinally along the edge of the frame (30), in particular in a slot (35) of the frame (30).

10. Manufacturing method according to the preceding claim, wherein the separation wire (60) is then embedded in a sealing product (55), in particular silicone.

11. Manufacturing method according to the preceding claim, wherein the photovoltaic module (M) is then inserted into the groove (50) of the frame (30), in particular so that a portion of separation wire is arranged mainly on a front face (41) of the photovoltaic module (M).

12. Manufacturing method according to the preceding claim, wherein one end of the separation wire (60) is then detached over a portion of the length thereof, in particular around 1 cm, in order to position it to a lesser extent on the rear face (42) of the photovoltaic module (M), in particular passing over the rear face (42) of the photovoltaic module via the edge face (M) thereof.

13. Manufacturing method according to the preceding claim, wherein a portion of separation wire (60) is arranged non-parallel to the groove (50) of the frame (30), in particular perpendicularly to the groove of the frame, said wire portion being passed about the photovoltaic module (M) from the front face (41) to the rear face (42) thereof via the edge face thereof.

14. Method of disassembling a photovoltaic device according to any one of Claims 1 to 8,
wherein the separation wire (60) is pulled, in particular at one or both of the free ends thereof, in particular from the rear face (42) of the photovoltaic module (M).

15. Disassembly method according to the preceding claim, wherein the separation wire (60) is pulled parallel to an edge (40) of the photovoltaic module (M).

16. Disassembly method according to one of the two preceding claims, wherein a first free end of the separation wire (60) is pulled as far as a connecting element (70), and then a second free end of the separation wire is pulled as far as the connecting element (70).
